# EUROPEAN PATENT APPLICATION

(11) **EP 1 189 291 A2**
(43) Date of publication of application: **20.03.2002**
(21) Application number: 01307541.1
(22) Date of filing: 05.09.2001
(51) Int. Cl.: H01L 33/00

(54) **Chip type light emitting diode and method of manufacture thereof**

(30) Priority: 13.09.2000 JP 2000278087; 11.07.2001 JP 2001210604
(71) Applicant: Citizen Electronics Co., Ltd., Fujiyoshida-shi, Yamanashi-ken (JP)
(72) Inventor: Fukasawa, Koichi, Fujiyoshida-shi, Yamanashi (JP)
(74) Representative: Bubb, Antony John Allen

(57) **Abstract**

A chip type light emitting diode and a method of manufacture thereof are disclosed. The chip type light emitting diode can be mounted together with other electronic components on a mother board in the same process at one time and which is very useful as a light source for a liquid crystal backlight.

The chip type light emitting diode has a base portion mounted to one surface side of the mother board, a body portion extending from the base portion and adapted to pass through a hole in the mother board, and a light emitting portion provided on the body portion to emit light on the other surface side of the mother board. The base portion is provided with a pair of external connection electrodes electrically connected to the light emitting portion. The light emitting portion is sealed with a resin sealant block. In one example, when the base portion is mounted to the back surface side of the mother board, the light emitting portion is so arranged that its light emitting direction matches the light conduction direction of the liquid crystal backlight arranged on the mother board.

The method of manufacturing a chip type light emitting diode performs a plurality of steps to form a plurality of chip type light emitting diodes on a single collective circuit board and a final step of dividing the collective circuit board into individual chip type light emitting diodes.

## Description

The present invention relates to a chip type light emitting diode and a method of manufacture thereof.

### Description of the Prior Art

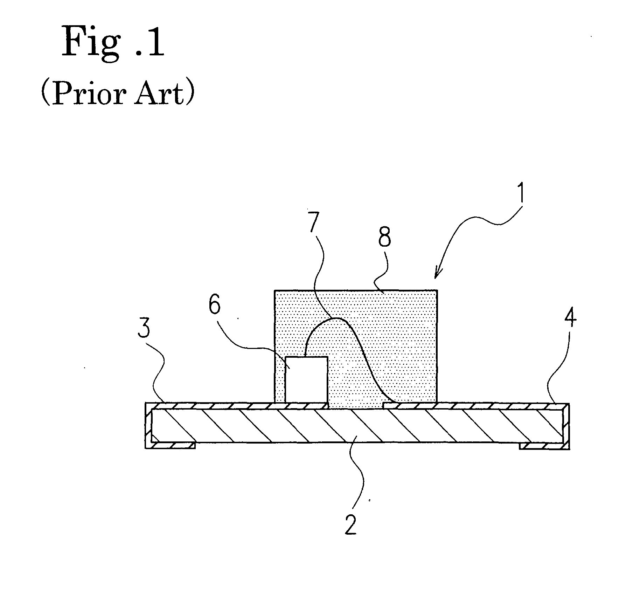

An example of a conventional chip type light emitting diode is shown at 1 in Fig. 1. The chip type light emitting diode 1 has a glass epoxy substrate 2, a cathode electrode 3 and an anode electrode 4 patterned on the upper surface of the glass epoxy substrate 2, a light emitting diode 6 secured to the cathode electrode 3 by a conductive adhesive (not shown), a bonding wire 7 connecting an upper surface electrode of the light emitting diode 6 and the anode electrode 4, and a resin sealant block 8 enclosing the bonding wire 7 and the light emitting diode 6 for protection.

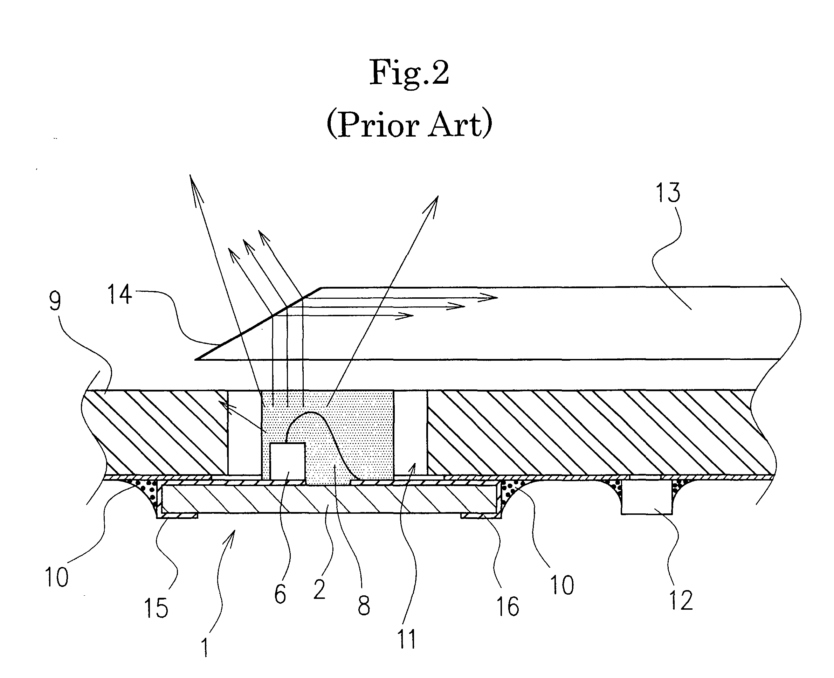

The chip type light emitting diode 1 described above is often mounted on the front surface of a mother board to emit light upward. In recent years, however, as a growing number of other electronic parts are mounted on the back surface of the mother board, a construction as shown in Fig. 2 is employed in which external connection electrodes 15, 16 of the glass epoxy substrate 2 are secured by solder 10 to the back surface of a mother board 9 and in which the resin sealant block 8 is inserted into a hole 11 in the mother board 9 to emit light upward. In such a construction, because both the chip type light emitting diode 1 and other electronic parts 12 need only to be mounted on one surface of the mother board 9, there is an advantage that the mounting process can be simplified compared with the conventional mounting method that mounts components on both surfaces of the mother board 9.

When the chip type light emitting diode 1 mounted on the back surface of the mother board 9 as described above is used as a light source for a liquid crystal backlight, because a light conduction direction of a light conductor plate 13 arranged on the front surface side of the mother board 9 differs from the light emitting direction of the light emitting diode 6, it is necessary to form at the end of the light conductor plate 13 a reflection surface 14 of about 45 degrees to deflect the light emitted upward from the chip type light emitting diode 1 by 90 degrees and introduce it into the light conductor plate 13. Of the rays of light emitted upward from the chip type light emitting diode 1, only those rays traveling almost vertically upward are guided into the light conductor plate 13. This raises a problem that the amount of incident light is small and that light losses occur at the reflection surface 14 of the light conductor plate 13.

For effective introduction of light into the light conductor plate 13, a construction may be conceived which uses a side-face-emitting, chip type light emitting diode to match the light conduction direction of the light conductor plate 13 with the light emitting direction of the chip type light emitting diode. In this case, however, since the chip type light emitting diode is mounted on the front surface of the mother board 9, the above-described one-surface mounting cannot be realized.

### SUMMARY OF THE INVENTION

One object of the present invention is to provide a chip type light emitting diode which is very useful as a light source for a liquid crystal backlight as it can be mounted on one surface side of a mother board and still emit light on the other surface side.

Another object of the present invention is to provide a chip type light emitting diode which can be mounted on one surface side of the mother board and thus can be mounted together with other electronic components to be mounted on the one surface side in the same process at one time.

Still another object of the present invention is to provide a chip type light emitting diode which can increase an amount of light incident on a light conductor plate of the liquid crystal backlight.

A further object of the present invention is to provide a chip type light emitting diode with a higher brightness.

A further object of the present invention is to provide a chip type light emitting diode capable of enhancing light convergence.

A further object of the present invention is to provide a chip type light emitting diode manufacturing method capable of making a large number of chip type light emitting diodes from a single collective circuit board.

In one embodiment of the present invention, the chip type light emitting diode according to this invention comprises: a base portion; a body portion extending from the base portion; a light emitting portion provided on the body portion; and a resin sealant block for sealing the light emitting portion.

In one example, the body portion extends from the base portion preferably virtually at right angles so that the base portion and the body portion together form a virtually T-shaped structure.

Further, the base portion is preferably provided with a pair of external connection electrodes electrically connected to the light emitting portion.

With this invention, because the body portion extends from the base portion of the chip type light emitting diode and has the light emitting portion, when the base portion is mounted to the mother board, the light emitting portion can emit light at a position spaced from the mother board. When the base portion and the body portion form a virtually T-shaped structure, it is possible to emit light at a position on the body portion spaced perpendicularly from a mounting surface on the mother board.

In another embodiment of the chip type light emitting diode according to the present invention, the base portion is mounted on one surface side of the mother board and the body portion passes through a hole formed in the mother board so that the light emitting portion on the body portion is exposed on the other surface side of the mother board.

With this invention, because the base portion is situated on one surface side of the mother board and the body portion passes through the hole in the mother board, when the base portion is mounted to the back surface side of the mother board for example, the light emitting portion can be exposed on the front surface side of the mother board.

In a further embodiment of the chip type light emitting diode of this invention, the light emitting portion is provided on a side face of the body portion and a light emitting direction of the light emitting portion is virtually aligned with a light conduction direction of a light conductor plate of a liquid crystal backlight arranged on a mother board.

With this invention, since the light emitting portion of the chip type light emitting diode is provided to the side face of the body portion, the light emitting direction of the light emitting portion can be aligned virtually with the light conduction direction of the light conductor plate of the liquid crystal backlight arranged on the mother board, increasing the amount of light entering the light conductor plate.

In a further embodiment of the chip type light emitting diode of this invention, the resin sealant block is provided with a convex lens portion.

With this invention, the directivity of light emitted from the light emitting diode can be enhanced by the lens portion.

In a further embodiment of the chip type light emitting diode of this invention, a reflection surface surrounding the light emitting diode element making up the light emitting portion inclines to expand outwardly.

With this invention, the rays of light emitted from the light emitting diode can be reflected by the reflection surface toward the same direction to enhance the convergence of light.

In a further embodiment of the chip type light emitting diode of this invention, a light-shielding surface is formed on a part of an external surface of the resin sealant block.

With this invention, a part of the light emitted from the light emitting diode is shielded by the light-shielding surface to prevent the light from scattering around the resin sealant block, thus enhancing the convergence of light toward a desired direction.

The chip type light emitting diode manufacturing method according to the present invention performs a plurality of steps to form a plurality of chip type light emitting diodes on a single collective circuit board and a final step of dividing the collective circuit board into individual chip type light emitting diodes.

With this invention, a large number of chip type light emitting diodes can be made easily from one collective circuit board.

These and other features and advantages of this invention will be described in more detail by referring to the accompanying drawings.

### BRIEF DESCRIPTION OF THE DRAWINGS

Fig. 1 is a cross-sectional view showing one example of a conventional light emitting diode.
Fig. 2 is a cross-sectional view when the conventional light emitting diode is mounted on a mother board.
Fig. 3. is a perspective view showing a first embodiment of a chip type light emitting diode according to the present invention.
Fig. 4 is a front view when the chip type light emitting diode is mounted on the mother board.
Fig. 5 is a cross-sectional view taken along the line A-A of Fig. 3 when the chip type light emitting diode is mounted on the mother board.
Fig. 6 is a perspective view showing a second embodiment of a chip type light emitting diode according to the present invention.
Fig. 7 is a perspective view showing a third embodiment of a chip type light emitting diode according to the present invention.
Fig. 8 is a perspective view showing a fourth embodiment of a chip type light emitting diode according to the present invention.
Fig. 9 is a perspective view showing a fifth embodiment of a chip type light emitting diode according to the present invention.
Fig. 10 is a perspective view showing a sixth embodiment of a chip type light emitting diode according to the present invention.
Fig. 11 is a perspective view showing a seventh embodiment of a chip type light emitting diode according to the present invention.
Fig. 12 is a flow chart showing a process of manufacturing the chip type light emitting diode of the first embodiment.
Fig. 13 is a perspective view showing how electrodes are patterned on a collective circuit board.
Fig. 14 is a perspective view showing how the light emitting diode elements are mounted on the collective circuit board.
Fig. 15 is a perspective view showing how the light emitting diode elements mounted on the collective circuit board are sealed with resin.
Fig. 16 is a cross-sectional view taken along the line B-B of Fig. 15.
Fig. 17 is a perspective view showing how the collective circuit board sealed with resin is divided in X and Y directions.

### DESCRIPTION OF THE PREFERRED EMBODIMENT

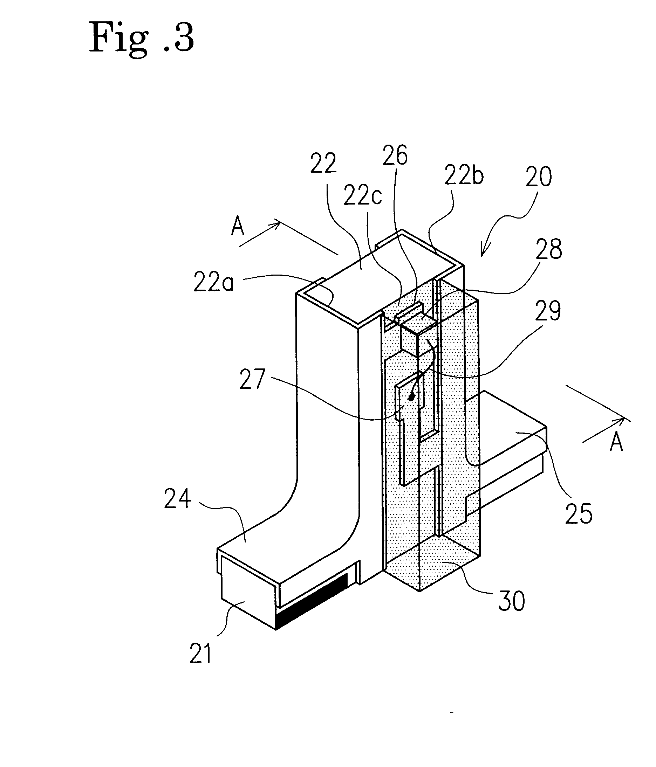

Now, some embodiments of a chip type light emitting diode according to the present invention will be described by referring to the accompanying drawings. Referring to Fig. 3 through Fig. 5, denoted 20 is a chip type light emitting diode as one embodiment of this invention. The chip type light emitting diode 20 is constructed of a glass epoxy substrate which has a base portion 21 secured to one surface of a mother board 23, e.g., a back surface, and a body portion 22 extending upward from an almost central part of the base portion 21. While, in this embodiment, the base portion 21 and the body portion 22 are formed integral, they may be formed separate. The base portion 21 extends horizontally on both sides of the body portion 22 and has a pair of external connection electrodes 24, 25 formed on an upper face thereof. The body portion 22 is of a quadrangular prism shape, on whose left and right side faces 22a, 22b the external connection electrodes 24, 25 continuously rise up to upper ends of the left and right side faces 22a, 22b. On a front face 22c of the body portion 22 are formed a cathode electrode 26 as a first electrode portion and an anode electrode 27 as a second electrode portion, the two electrodes being separated vertically. These cathode and anode electrodes 26 and 27 are connected to the external connection electrodes 24, 25, respectively.

On a surface of the cathode electrode 26 is mounted a light emitting diode element 28 as a light emitting portion which has its bottom electrode secured to the cathode electrode 26 through a conductive adhesive (not shown) and its top electrode connected to the anode electrode 27 through a bonding wire 29. Thus, current is supplied from the external connection electrodes 24, 25 through the cathode electrode 26 and the anode electrode 27 to the light emitting diode element 28 which then emits light. Depending on its polarity, the light emitting diode element 28 may be mounted on the anode electrode 27. There are no limitations as to the kind of the light emitting diode element 28 or the color of light emitted.

The light emitting diode element 28 and the bonding wire 29 are covered with a resin sealant block 30 provided on the front face 22c of the body portion 22. The resin sealant block 30 is formed in block on the front face 22c of the body portion 22 and encloses the cathode electrode 26 and the anode electrode 27 in addition to the light emitting diode element 28 and the bonding wire 29. The material of the resin sealant block 30 may be a transparent epoxy resin.

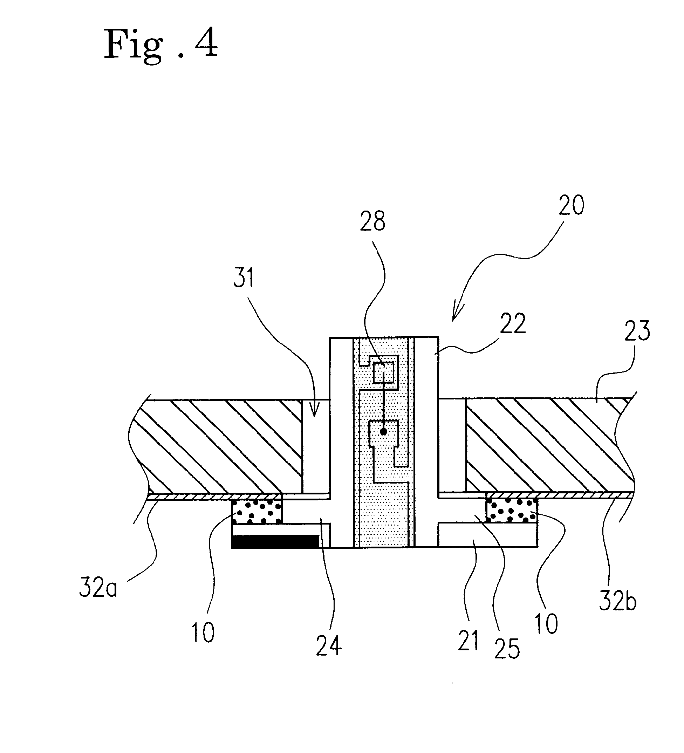

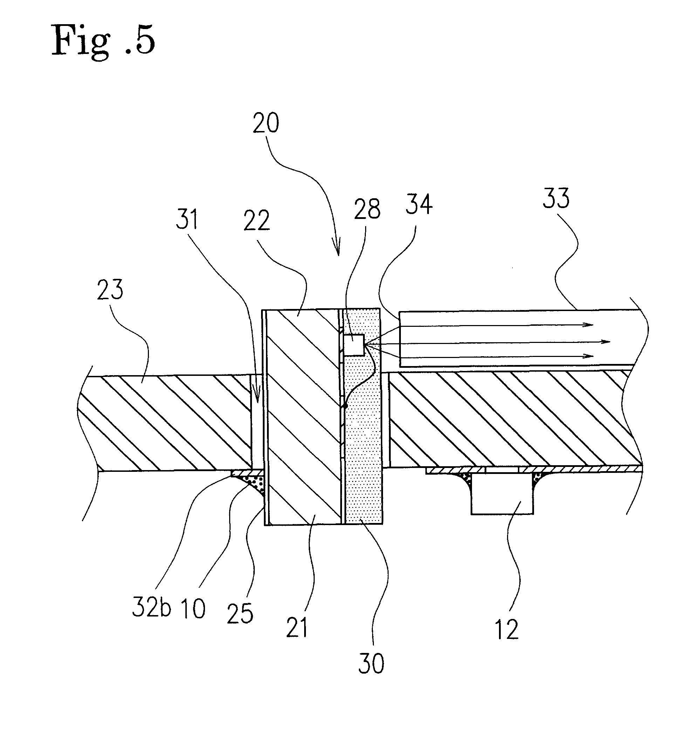

Fig. 4 and Fig. 5 show the chip type light emitting diode 20 mounted on the mother board 23. The mother board 23 is formed with a hole 31 through which the body portion 22 of the chip type light emitting diode 20 is passed from the back surface side of the mother board 23. The base portion 21 of the chip type light emitting diode 20 engages the back surface of the mother board 23 at a peripheral portion of the hole 31, with the external connection electrodes 24, 25 on the base portion 21 rigidly secured by a solder 10 to printed circuits 32a, 32b of the mother board 23.

At this time, the body portion 22 of the chip type light emitting diode 20 passes through the hole 31 of the mother board 23 from the back surface side and projects out on the other surface side, i.e., the front surface side. The light emitting diode element 28 mounted on the front face 22c of the body portion 22 and facing forwardly is exposed from the front surface of the mother board 23. Hence, when it is to be used as a light source for a light conductor plate of a liquid crystal backlight, the chip type light emitting diode 20 is set so that the light emitting diode element 28 is situated close to a side end face 34 of a light conductor plate 33 mounted on the front surface side of the mother board 23, as shown in Fig. 5. The side end face 34 of the light conductor plate 33 is vertically straight and does not form a reflection surface as in the conventional construction. In this construction, when light is emitted from the light emitting diode element 28 toward the side end face 34 of the light conductor plate 33, the light emitting direction almost agrees with the light conduction direction of the light conductor plate 33 and thus the light entering the side end face 34 of the light conductor plate 33 travels horizontally straight through the light conductor plate 33 without being deflected. Since the light emitting diode element 28 is arranged close to the side end face 34 of the light conductor plate 33, the amount of light entering the light conductor plate 33 increases. Further, because the light is not deflected by a reflection surface as in the conventional construction, the loss of light becomes very small.

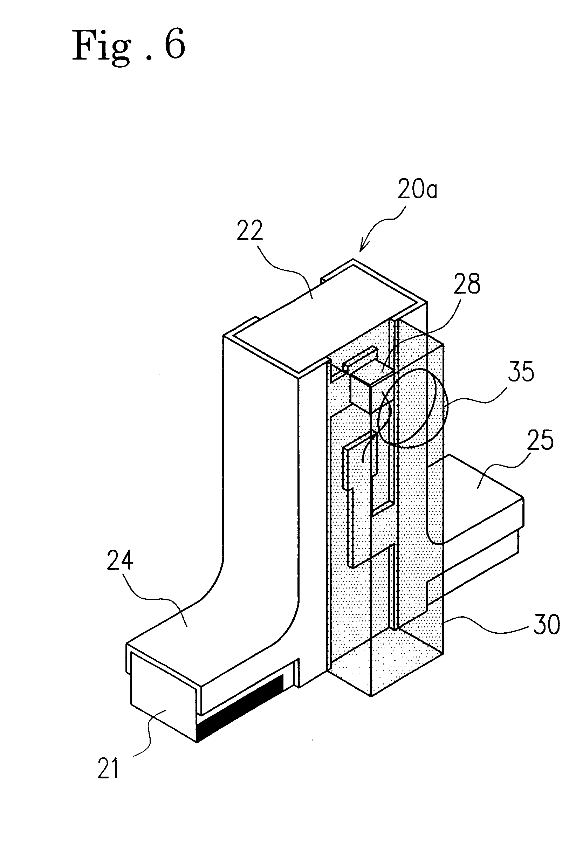

Fig. 6 shows a second embodiment of the chip type light emitting diode according to the present invention. The chip type light emitting diode 20a has a hemispherical lens portion 35 integrally formed with a resin sealant block 30 provided on the front face of the body portion 22 so that the directivity of light emitted from the light emitting diode element 28 is enhanced by the lens portion 35 to increase brightness. Hence, the lens portion 35 is situated over the light emitting diode element 28 so that the light emitted from the light emitting diode element 28 can easily be focused on a point. The construction of other components than the lens portion 35 is similar to that of the chip type light emitting diode 20 of the first embodiment. So, these components are given like reference numbers and their detailed description is omitted.

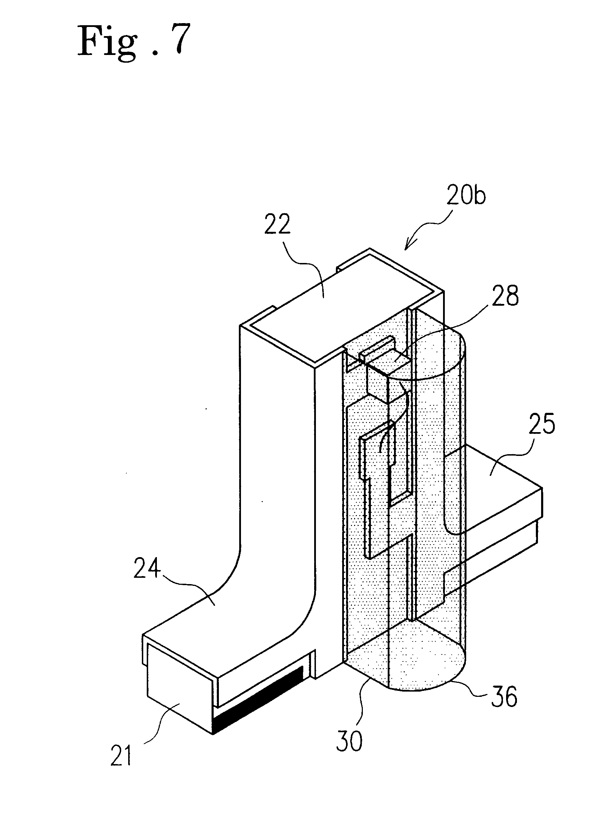

Fig. 7 shows a third embodiment of the chip type light emitting diode according to the present invention. The chip type light emitting diode 20b has a semicylindrical lens portion 36 formed integral with the resin sealant block 30 provided on the front face of the body portion 22. In this embodiment too, the light emitted from the light emitting diode element 28, because of the lens portion 36, easily converges toward the center and does not easily scatter to the left and right side, thereby enhancing the directivity of light as in the second embodiment. The construction of other components than the lens portion 36 is similar to that of the chip type light emitting diode 20 of the first embodiment. So, these components are given like reference numbers and their detailed description is omitted.

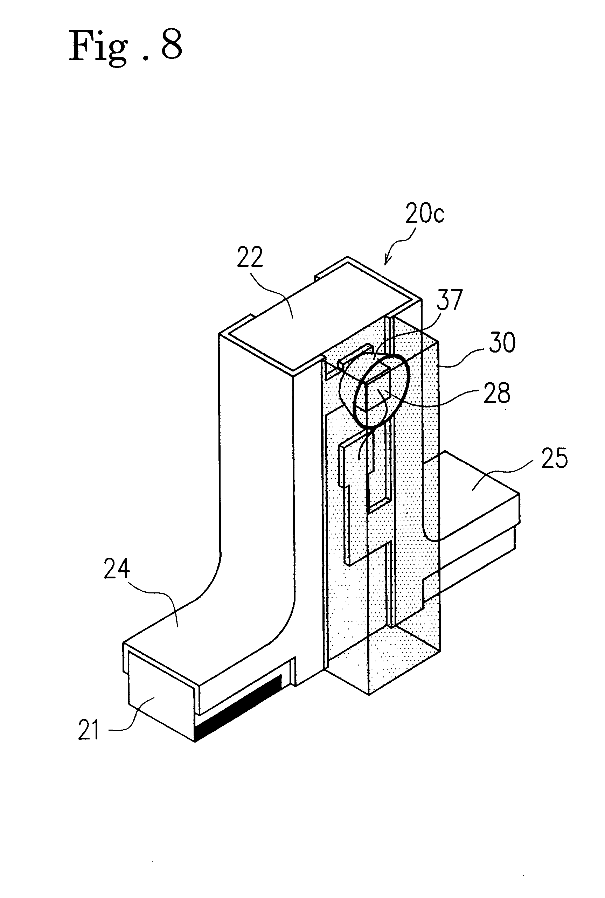

Fig. 8 shows a fourth embodiment of the chip type light emitting diode according to the present invention. The chip type light emitting diode 20c has a cup-shaped reflection frame 37 enclosing the light emitting diode element 28 to reflect light emitted from the light emitting diode element 28 by an inner circumferential surface of the reflection frame 37 and thereby enhance the forward convergence of light. The inner circumferential surface of the reflection frame 37 is tapered and also coated with a white paint or plated with silver. The construction of other components than the reflection frame 37 is similar to that of the chip type light emitting diode 20 of the first embodiment. So, these components are given like reference numbers and their detailed description is omitted.

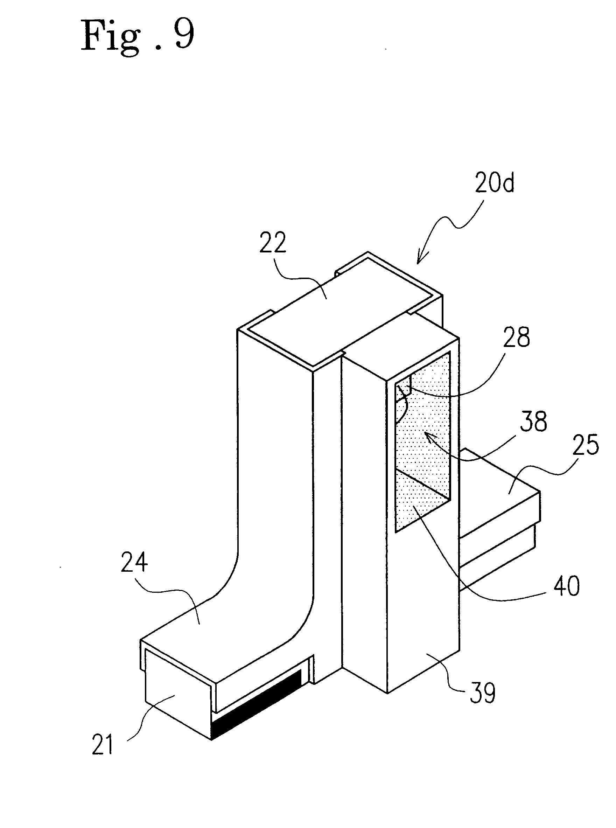

Fig. 9 shows a fifth embodiment of the chip type light emitting diode according to the present invention. The chip type light emitting diode 20d has a bulged body 39, which has a recess 38, integrally mounted on the front face of the body portion 22. The light emitting diode element 28 is arranged in the recess 38 which is filled with a light transmitting resin 40 to seal the light emitting diode element 28. In this embodiment too, the light emitted from the light emitting diode element 28 is reflected by the inner circumferential surface of the recess 38, thus enhancing the forward convergence of light and therefore brightness. The inner circumferential surface of the recess 38 is inclined to expand outwardly and coated with a white paint or plated with silver to enhance the reflectivity. The construction of other components than the bulged body 39 with the recess 38 is similar to that of the chip type light emitting diode 20 of the first embodiment. So, these components are given like reference numbers and their detailed description is omitted.

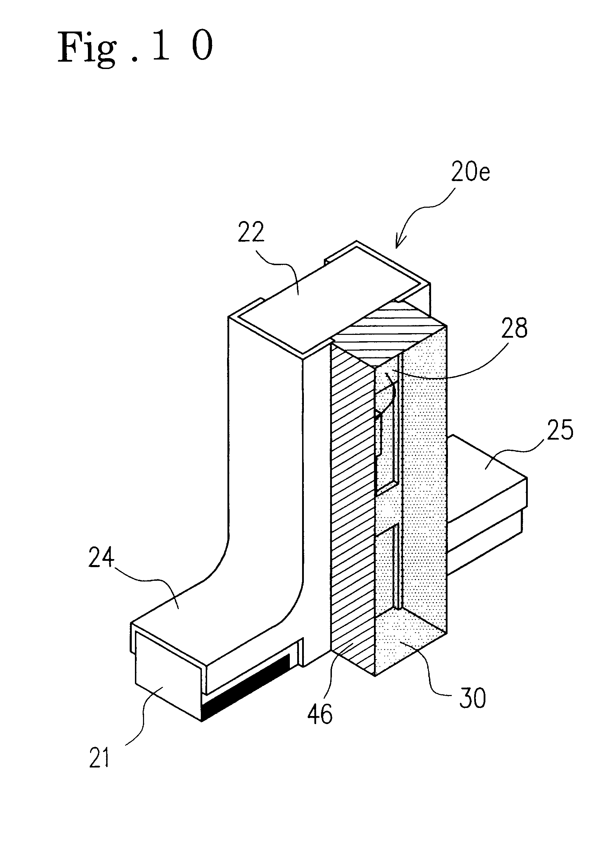

Fig. 10 shows a sixth embodiment of the chip type light emitting diode according to the present invention. The chip type light emitting diode 20e light-shields the entire outer circumferential surface of the resin sealant block 30 so that the light emitted from the light emitting diode element does not scatter around the resin sealant block, thus enhancing the forward convergence of light. That is, the side faces and top and bottom faces of the resin sealant block are coated or applied with a light-shielding paint film or light-shielding sheet, or plated with a metal to form light-shielding surfaces 46 to ensure that the light emitted from the light emitting diode element 28 is directed only toward the unshielded front of the resin sealant block 30. The construction is similar to that of the chip type light emitting diode 20 of the first embodiment except that the light-shielding surfaces 46 are provided to the resin sealant block 30. So, the components are given like reference numbers and their detailed description is omitted.

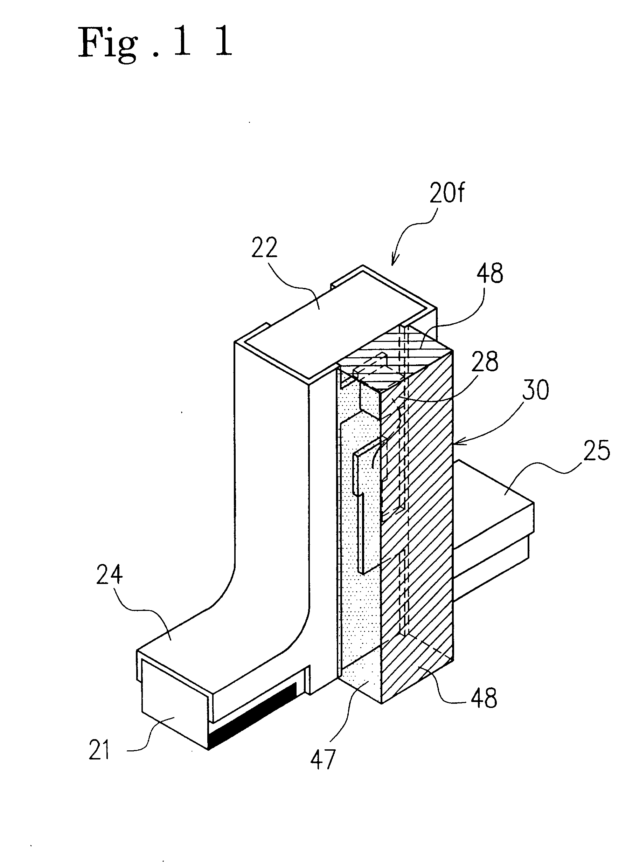

Fig. 11 shows a seventh embodiment of the chip type light emitting diode according to the present invention. The chip type light emitting diode 20f, too, light-shields the resin sealant block 30 protruding from the front of the body portion 22 to enhance the convergence of light emitted from the light emitting diode element 28 as in the sixth embodiment. In this embodiment, light-shielding surfaces 48 are formed over the entire surface of the resin sealant block 30 except one side face 47, i.e., over the opposite side face, the top and bottom faces and the front face of the resin sealant block 30, so that the light emitted from the light emitting diode element 28 goes out through only the one side face 47 of the resin sealant block 30. The construction is similar to that of the chip type light emitting diode 20 of the first embodiment except that the light-shielding surfaces 48 are provided to the resin sealant block 30. So, the components are given like reference numbers and their detailed description is omitted.

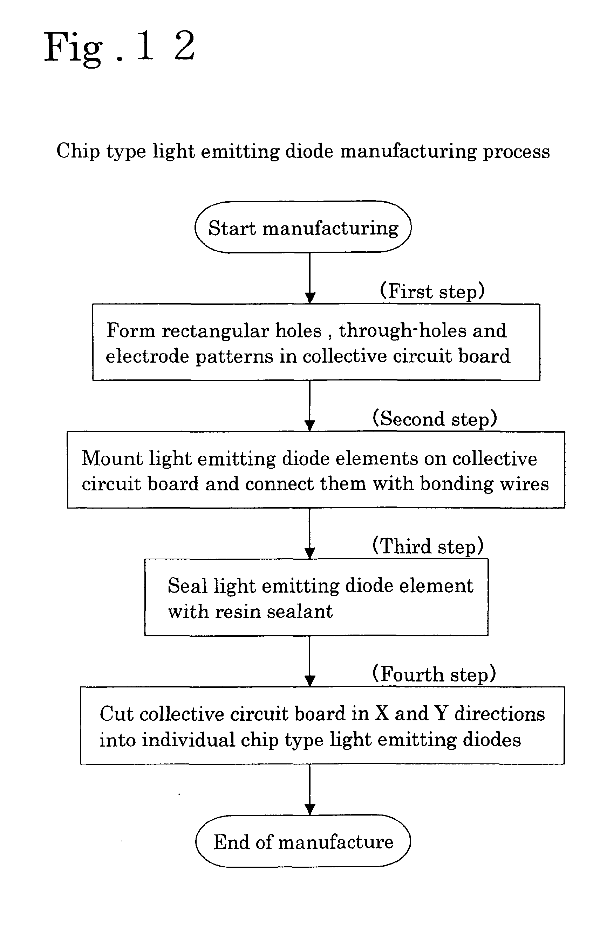

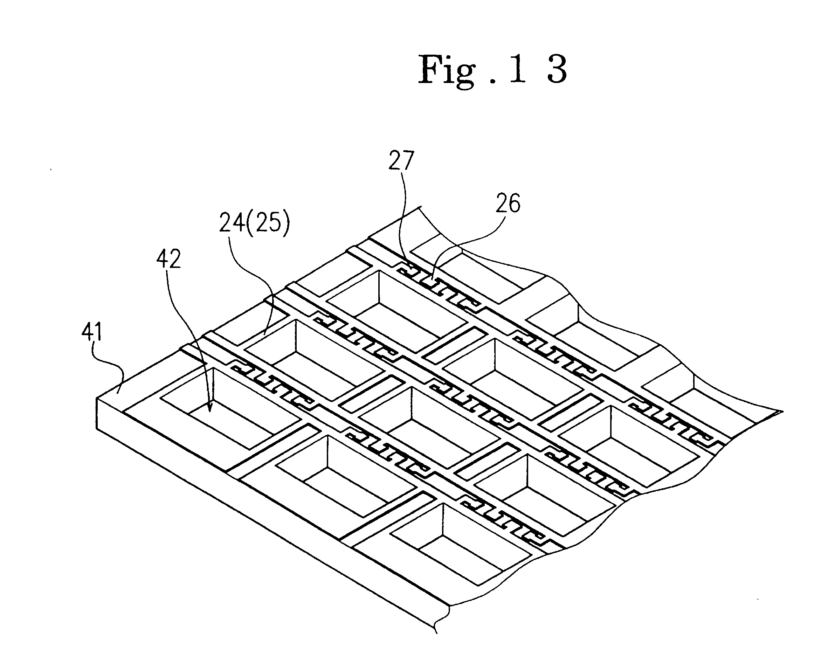

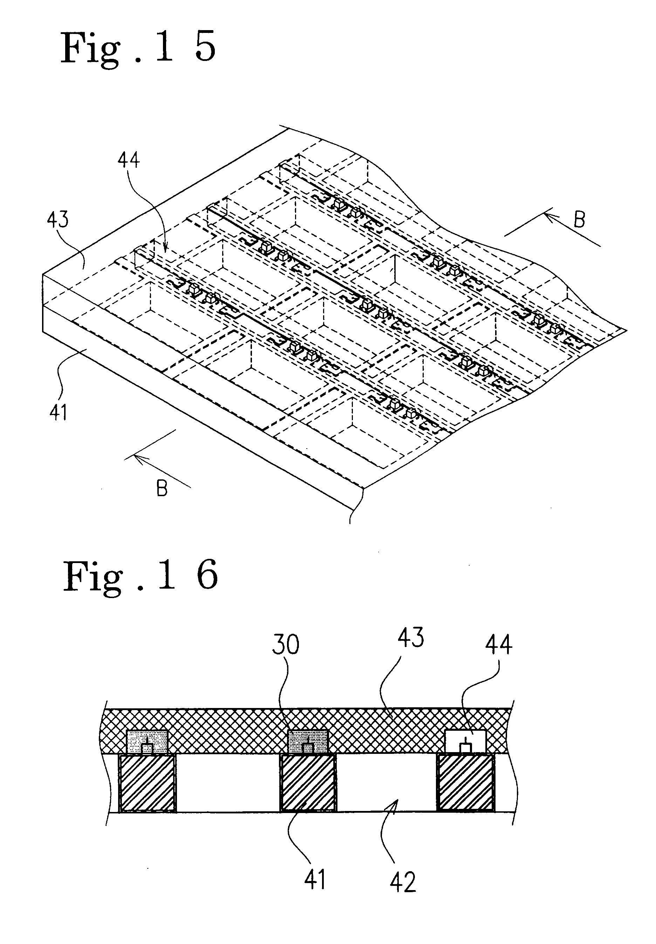

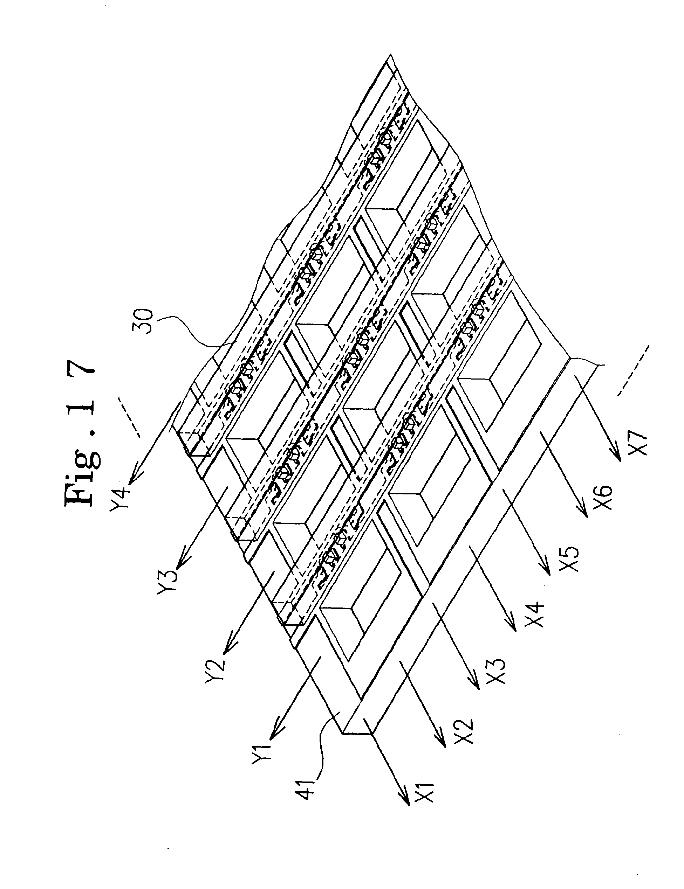

Next, the process of manufacturing the chip type light emitting diode 20 of the first embodiment will be explained. Fig. 12 shows the whole process of the manufacturing method according to this invention, and Fig. 13 through Fig. 17 show individual manufacturing processes in the order that they occur. First, as shown in Fig. 12 and Fig. 13, one collective circuit board 41 is formed with many rectangular holes 42 in columns and rows at equal intervals to form plated through-holes on inner circumferential walls of the holes 42. The collective circuit board 41 is also patterned at the front and back surfaces with external connection electrodes 24, 25, cathode electrodes 26 and anode electrodes 27 (first step).

The collective circuit board 41 is generally constructed of a glass epoxy board, and the plated through-holes and electrode patterns are formed by an etching or vapor deposition method.

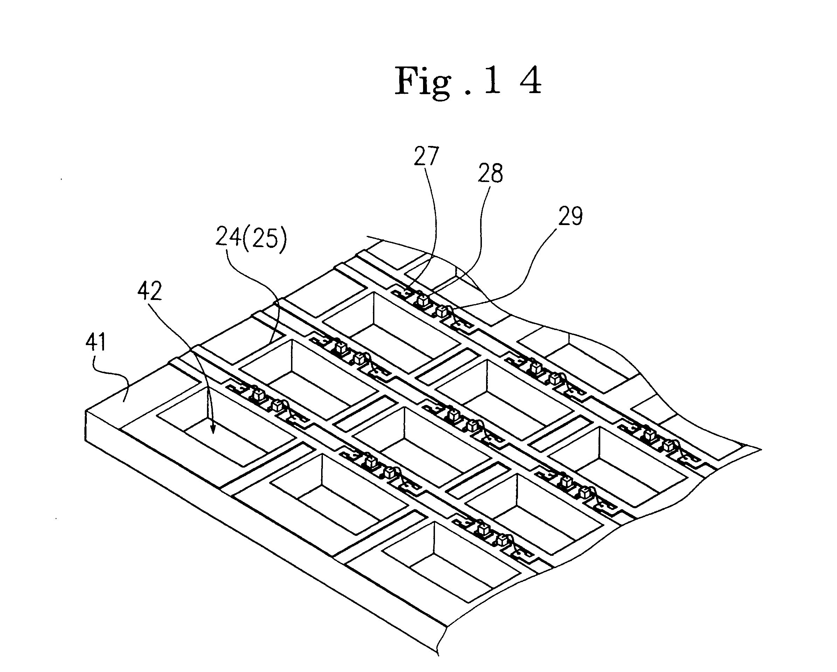

Next, as shown in Fig. 12 and Fig. 14, the light emitting diode elements 28 are secured through a conductive adhesive to the cathode electrodes 26, and the ends of the bonding wires 29 extending from the upper surfaces of the light emitting diode elements 28 are bonded to the anode electrodes 27 (second step).

Next, as shown in Fig. 12, Fig. 15 and Fig. 16, a mold 43 is placed on the collective circuit board 41. The mold 43 has recesses 44 at positions corresponding to where the light emitting diode elements 28 and the bonding wires 29 are arranged. The mold 43, when placed over the collective circuit board 41, covers the entire external connection electrodes 24, 25 and rectangular holes 42. The recesses 44 of the mold 43 put on the collective circuit board 41 are filled with colorless, transparent epoxy resin to seal the light emitting diode elements 28 and the bonding wires 29. The epoxy resin filled into the recesses 44 is hardened by a curing process (third step).

In the final step, as shown in Fig. 12 and Fig. 17, the mold 43 is taken off the collective circuit board 41. At this time, the light emitting diode elements 28 and the bonding wires 29 are completely sealed with the resin sealant blocks 30 filled into the recesses 44 of the mold 43. Then, the collective circuit board 41 is cut along predetermined X axes (X1, X2, ..., Xn) and Y axes (Y1, Y2, ..., Yn) as shown to divide the board into single chip type light emitting diodes (fourth step).

With the above-described series of steps finished, the T-shaped chip type light emitting diode 20 having the base portion 21 and the body portion 22 extending almost vertically upward from the base portion 21 as shown in Fig. 3 is completed. These chip type light emitting diodes 20 are taped and mounted on the mother board 23 as shown in Fig. 4 and Fig. 5.

In the above embodiment the light emitting diode element 28 is mounted on the front face 22c of the body portion 22 extending vertically upward relative to the mother board 23 to emit light horizontally parallel to the mother board 23. When the angle of the side end face 34 of the light conductor plate 33 differs from that of the above embodiments, it is desired that the mounting angle of the light emitting diode element 28 be changed according to the side end face angle to virtually align the light emitting direction of the light emitting diode element 28 with the light conduction direction.

While in the above embodiments the chip type light emitting diode 20 of this invention has been described to be used as a light source for the light conductor plate 33 of a liquid crystal backlight, it can of course be used for other applications, for example, as an indicator for cellular phones and PDAs (personal digital assistants).

As described above, with the chip type light emitting diode of this invention, because a light emitting portion is provided on the body portion extending from the base portion, when the base portion is mounted to the back surface of the mother board with the body portion passed through a hole in the mother board, the light emitting portion can be exposed on the front surface side. This arrangement is extremely useful as a light source for the liquid crystal backlight. When the chip type light emitting diode is T-shaped in particular, the light is emitted horizontally from the body portion so that the light emitting direction of the light emitting portion is aligned with the light conduction direction of the light conductor plate arranged on the front surface side of the mother board, increasing the amount of light incident on the light conductor plate and decreasing loss of light.

Further, because the chip type light emitting diode of this invention can be mounted on one surface side of the mother board, it can be mounted together with other electronic components to be mounted on the one surface side in the same process at one time, thereby simplifying the mounting process and shortening the time required for mounting.

Further, with the method of manufacturing the chip type light emitting diode according to this invention, a large number of chip type light emitting diodes can be made easily from a single collective circuit board, thus reducing the manufacturing cost.

It should also be understood that the present invention is not limited to these embodiments described above but various modifications and changes may be made without departing from the spirit of the invention.

## Claims

1. A chip type light emitting diode comprising:
a base portion;
a body portion extending from said base portion;
a light emitting portion provided on said body portion; and
a resin sealant block for sealing said light emitting portion.

2. The chip type light emitting diode according to claim 1, wherein said base and body portions combine to form a T-shaped structure.

3. The chip type light emitting diode according to claim 1, wherein said base portion is provided with a pair of external connection electrodes electrically connected to said light emitting portion.

4. The chip type light emitting diode according to claim 1, wherein said base portion is mounted on one surface side of a mother board and said body portion passes through a hole formed in the mother board so that the light emitting portion on the body portion is exposed on the other surface side of said mother board.

5. The chip type light emitting diode according to claim 1, wherein said light emitting portion is provided on a side face of said body portion and a light emitting direction of the light emitting portion is virtually aligned with a light conduction direction of a light conductor plate of a liquid crystal backlight arranged on a mother board.

6. The chip type light emitting diode according to claim 1, wherein said resin sealant block is provided with a convex lens portion.

7. The chip type light emitting diode according to claim 1, wherein a reflection surface surrounding a light emitting diode element making up said light emitting portion inclines to expand outwardly.

8. The chip type light emitting diode according to claim 1, wherein a light-shielding surface is formed on a part of an external surface of said resin sealant block.

9. A method of manufacturing a chip type light emitting diode comprising:
a step of forming a number of rectangular holes in a collective circuit board in columns and rows at equal intervals, forming through-holes on inner circumferential surfaces of said rectangular holes, and providing between the plurality of holes a plurality of base portions, body portions vertically extending one from each of said base portions, external connection electrodes formed on said base portions, and first and second electrode portions formed on said body portions;
a step of arranging light emitting portions on said first electrode portions and connecting said light emitting portions and said second electrode portions by bonding wires;
a step of putting on said collective circuit board a mold formed with recesses to accommodate said light emitting portions and bonding wires in such a manner that said recesses match said light emitting portions and said bonding wires and sealing said light emitting portions and said bonding wires by filling a resin into said recesses; and
a step of, after removing said mold, cutting said collective circuit board in column and row directions to form chip type light emitting diodes each comprising said base portion having said external connection electrodes and said body portion having said first and second electrode portions and said light emitting portion.
